(19) Europäisches Patentamt
European Patent Office
Office européen des brevets

(11) Numéro de publication: **0 202 177**
**A1**

# (12) DEMANDE DE BREVET EUROPEEN

(21) Numéro de dépôt: **86420114.0**

(22) Date de dépôt: **30.04.86**

(51) Int. Cl.[4]: **C 08 G 77/62**
C 08 L 83/16

(30) Priorité: **06.05.85 FR 8506829**

(43) Date de publication de la demande:
**20.11.86 Bulletin 86/47**

(84) Etats contractants désignés:
**AT BE CH DE FR GB IT LI LU NL SE**

(71) Demandeur: **RHONE-POULENC SPECIALITES CHIMIQUES**
**"Les Miroirs" 18, Avenue d'Alsace**
**F-92400 Courbevoie(FR)**

(72) Inventeur: **Porte, Hugues**
**65, rue de Sèze**
**F-69006 Lyon(FR)**

(72) Inventeur: **Lebrun, Jean-Jacques**
**24, rue Pierre Brunier**
**F-69300 Caluire-et-Cuire(FR)**

(74) Mandataire: **Seugnet, Jean Louis et al,**
**RHONE-POULENC INTERSERVICES Service Brevets Chimie Centre de Recherches de Saint-Fons B.P. 62**
**F-69192 Saint-Fons Cédex(FR)**

## (54) Composition organopolysilazane comportant des générateurs de radicaux libres et réticulable par apport d'énergie.

(57) La présente invention concerne une composition organopolysilazane pouvant réticuler par apport d'énergie et comportant une quantité efficace de générateurs de radicaux libres. L'apport d'énergie permettant d'engendrer lesdits radicaux peut être effectué sous forme de chaleur, de rayonnement ultraviolet, d'un faisceau d'électrons etc...

Les compositions organopolysilazanes réticulées présentent une tenue thermique élevée et sont utilisables notamment, après pyrolyse, comme précurseurs de produits céramiques.

EP 0 202 177 A1

Croydon Printing Company Ltd.

# COMPOSITION ORGANOPOLYSILAZANE COMPORTANT DES GENERATEURS DE RADICAUX LIBRES ET RETICULABLE PAR APPORT D'ENERGIE

La présente invention concerne une composition organopolysilazane comportant des générateurs de radicaux libres et réticulable par apport d'énergie.

Les organopolysilazanes dénommés par la suite polysilazanes sont des produits bien connus se présentant sous forme de monomères, d'oligomères et de polymères cycliques ou linéaires et également sous la forme de polymères résineux. Ces polysilazanes peuvent être préparés suivant une large variété de procédés à partir d'une gamme étendue de produits de départ.

Ces polysilazanes peuvent être notamment mis en forme et être pyrolysés sous forme de $Si_3N_4$, SiC ou leurs mélanges. Pour fabriquer du nitrure de silicium, il existe une autre voie qui consiste à faire réagir à haute température et en phase vapeur des chlorosilanes ($SiCl_4$, $HSiCl_3$ et $H_2SiCl_2$) sur l'ammoniac. Selon cette méthode aboutissant directement à un produit en poudre, il est difficile de fabriquer des objets en forme, en particulier, des fibres. Par contre, les polysilazanes peuvent être filés en fibres continues dont la pyrolyse aboutit à des fibres céramiques.

Ils peuvent être mis sous forme de pellicules plus ou moins minces, de pièces massives moulées, et être utilisés comme liant pour fibre céramique ou fibre de carbone et comme liant de frittage pour pièces céramiques poreuses.

Il existe toutefois des difficultés pour mettre en forme de façon aisée et économique ces polysilazanes sous forme de fibres ou de revêtements qui, après pyrolyse, donnent des produits céramiques sous forme de fibre, de pellicules, de revêtements plus ou moins minces et de pièces moulées.

Dans le brevet américain US.A 3.853.567 on a essayé de donner une première solution au problème ci-dessus.

Selon ce brevet on propose un procédé de fabrication de pièces en forme telles que des fibres comportant du carbure de silicium, du nitrure de silicium ou leurs mélanges avec d'autres produits céramiques, en effectuant un premier traitement thermique à une

température comprise entre 200°C et 800°C d'un polysilazane, en vue d'obtenir une résine carbosilazane fusible qui peut être filée à l'état fondu puis pyrolysée à une température comprise entre 800 et 2000°C.

Le brevet ci-dessus constitue certes un progrès important mais il présente le double inconvénient de nécessiter un premier traitement thermique à une température pouvant être déjà très élevée (200-800°C) et de travailler un carbosilazane à l'état fondu sous des conditions anhydres et en atmosphère inerte. De plus, le rendement pondéral en céramique peut être insuffisant.

Dans la demande de brevet japonais Kokai n°77/160 446, on décrit un procédé de polymérisation d'organopolysilazanes de haut poids moléculaire en utilisant comme catalyseur de traitement des organopolysilazanes, des terres acides. Ce procédé présente cependant l'inconvénient majeur de nécessiter la séparation du catalyseur solide par filtration impliquant l'emploi de solvant dans le cas de polymères atteignant des viscosités élevées.

La présente invention a pour but de résoudre le problème ci-dessus et de proposer un moyen simple, efficace, économique et de mise en oeuvre aisée pour préparer sous des formes les plus diverses (fils, articles moulés, revêtements, pellicules etc...) des nouvelles compositions organopolysilazanes qui, lors de leur pyrolyse, à une température comprise entre 1000 et 2000°C donnent des produits céramiques présentant d'excellentes propriétés.

Il est en outre souhaitable et c'est un autre but de la présente invention de pouvoir disposer facilement d'une composition organopolysilazane qui soit assez stable à l'hydrolyse et qui conduise par pyrolyse avec un rendement pondéral élevé, à un matériau céramique. Il est nécessaire pour cela que la composition organopolysilazane présente lors de la pyrolyse une bonne tenue thermique tout en demeurant solidaire du support à revêtir et/ou à imprégner.

Ces buts et d'autres sont atteints par la présente invention qui concerne en effet une composition organopolysilazane susceptible de réticuler par apport d'énergie, caractérisée en ce qu'elle comporte une quantité efficace d'au moins un générateur de radicaux

libres. En vue de réticuler la composition organopolysilazane, on apporte à ladite composition de l'énergie suivant une quantité suffisante et sous une forme susceptible d'engendrer lesdits radicaux libres, comme de la chaleur, un rayonnement ultraviolet, un faisceau d'électrons etc...

Comme organopolysilazane (1) on peut utiliser n'importe quel produit de réaction (a) d'au moins un organohalogénosilane de formule :

$R_a\ Y_{4-a}\ Si$ (I)

dans laquelle les radicaux R identiques ou différents sont choisis parmi l'atome d'hydrogène, un radical alkyle linéaire ou ramifié éventuellement halogéné ayant de 1 à 12 atomes de carbone, un radical cycloalkyle ayant de 5 à 7 atomes de carbone et un radical aryle tel que le radical phényle et naphtyle, un radical arylalkyle ou alkylaryle dont la partie alkyle linéaire ou ramifiée comporte de 1 à 6 atomes de carbone, Y étant un atome d'halogène, de préférence le chlore et a étant 0, 1, 2 ou 3, sur

(b) un composé organique ou organosilylé comportant au moins un groupement $NH_2$ ou NH comme par exemple l'ammoniac, les amines primaires ou secondaires, les silylamines, les amides, les hydrazines, les hydrazides, etc...

Comme organohalogénosilane utilisable seul ou en mélange on peut citer :

$(CH_3)_2\ Si\ Cl_2$, $(CH_3)_3\ SiCl$, $CH_3SiCl_3$, $SiCl_4$, $CH_3HSiCl_2$
$(CH_3)_2\ Si(CH_2\ Cl)_2$, $(CH_3)_3\ SiCH_2\ Cl$, $CH_3\ Si(CH_2\ Cl)_3$, $H_2SiCl_2$
$(C_6H_5)_2\ SiCl_2$, $(C_6H_5)(CH_3)Si\ Cl_2$, $C_6\ H_5\ SiCl_3$, $(CH_3)_2HSiCl$
$(CH_3)(CH_3CH_2)Si\ Cl_2$, $HSiCl_3$

Ces polysilazanes sont bien connus et aisés à préparer. Ils englobent plus spécifiquement :

- les polymères linéaires répondant aux formules :

$H_2N\ (R_2SiNH)_p\ SiR_2\ NH_2$ (II)

et

$R_3SiNH(R_2\ SiNH)_{p'}\ SiR_3$ (III)

dans lesquels R a la signification ci-dessus ; p et p' sont des nombres entiers pouvant être compris entre 1 et 1000 généralement entre 3 et 300.

Les polymères de formule (II) peuvent être préparés par mise en contact de diorganodichlorosilanes avec de l'ammoniac, et ceux

de formule (III) par réaction d'ammoniac sur un triorganochlorosilane ou un mélange de diorganodichlorosilane et de triorganochlorosilane (voir brevet français FR - A. 1.086.932, brevet américain US-A. 2.564.674).

De façon générale, la réaction d'organohalogénosilane sur une organoamine est décrite dans les brevets américains US-A. 3.853.567 et 3.892.583 et la réaction d'organohalogénosilane sur un disilazane est décrite dans le brevet belge BE-A. 888.787.

- les polymères cycliques répondant à la formule :

$$(R_2\ SiNH)_n \qquad (IV)$$

dans laquelle n est compris entre 3 et 10, généralement n = 3 ou 4 et R a la signification donnée pour la formule (I) ci-dessus. Ils sont décrits notamment dans le brevet britannique GB-A. 881.178.

- les polymères résineux formés de motifs choisis parmi ceux de formule $R_3\ SiNH_{0,5}$, $R_2\ SiNH$, $RSiNH_{1,5}$, $Si(NH)_2$.

Ils sont avantageusement préparés par mise en contact des organochlorosilanes correspondant ou des mélanges de ces silanes, avec de l'ammoniac, de préférence en milieu solvant organique (voir brevets français FR-A. 1.379.243, FR-A. 1.392.853 et FR-A. 1.393.728).

Ces polymères résineux renferment en quantité prépondérante des liaisons Si-NH-Si et en quantité moindre des liaisons $SiNH_2$ et comportent parfois en dehors des polymères réticulés, des polymères linéaires et cyliques ; ces derniers ne pouvant se former que si, parmi les organochlorosilanes de départ se trouvent des diorganodichlorosilanes.

Les organopoly(disilyl)silazanes peuvent être préparés par action (a) d'un composé organique ou organosilylé comportant au moins un groupement $NH_2$ ou NH comme par exemple l'ammoniac, les amines primaires ou secondaires, les silylamines, les amides, les hydrazines et les hydrazides, etc... sur (b) au moins un organohalogénodisilane de formule :

$$R_b\ Y_{3-b}\ Si\ Si\ R_c\ Y_{3-c} \qquad (V)$$

dans laquelle les radicaux R identiques ou différents ont la même signification que ci-dessus et b est égal à 0,1, 2 ou 3 et c est égal à 0, 1 ou 2 et Y est un halogène, généralement le chlore.

Comme exemple de composés de formule (V) on peut citer :

$(CH_3)_2$ ClSiSi $(CH_3)_2$ Cl, $(CH_3)_2$Cl SiSi $CH_3$ $Cl_2$

$CH_3$ $Cl_2$ SiSi $CH_3$ $Cl_2$

Comme exemples de composés comportant au moins un groupement $NH_2$ ou NH et utilisable pour la synthèse des organopolysilazanes ci-dessus, on peut citer : l'ammoniac, la méthylamine, la diméthylamine, l'éthylamine, la cyclopropylamine, l'hydrazine, la méthylhydrazine, l'éthylènediamine, la tétraméthylènediamine, l'hexaméthylènediamine, l'aniline, la méthylaniline, la diphénylamine, la toluidine, la guanidine, l'aminoguanidine, l'urée, l'hexaméthyldisilazane, le diphényltétraméthyldisilazane ; le tétraphényldiméthyldisilazane, le tétraméthydivinyldisilazane, le diméthyldiphényldivinyldisilazane et le tétraméthyldisilazane.

La réaction d'halogénodisilane, en présence éventuellement d'halogenosilane, sur l'ammoniac est décrite dans le brevet européen EP-A 75826. La réaction d'halogénodisilane sur un disilazane est décrite dans le brevet français FR-A 2.497.812. Tous les documents ci-dessus de préparation de polysilazanes sont cités comme référence dans la présente description.

Selon un mode de réalisation préféré, les organopolysilazanes (2) de départ comportent par molécule au moins 1 groupe ≡ $SiR_1$, $R_1$ étant un radical hydrocarboné présentant une insaturation alcénique ou alcynique. On s'est en effet aperçu conformément à la présente invention que les organopolysilazanes (2) présentant par molécule au moins 1 groupe ≡ $SiR_1$ réticulent plus rapidement, plus complètement et à plus basse température qu'un organopolysilazane (1) ne présentant pas de tels groupements ≡ $SiR_1$ et ceci pour une même teneur en générateurs de radicaux libres.

La présente invention vise donc plus particulièrement une composition organopolysilazane, caractérisée en ce qu'elle comporte un organopolysilazane (2) présentant, par molécule, au moins 2 motifs choisis parmi les motifs de formule (Ia), (Ib) et (Ic) :

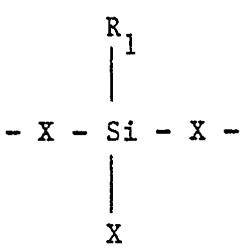
(Ia)

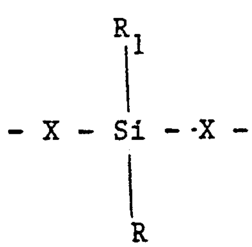
(Ib)

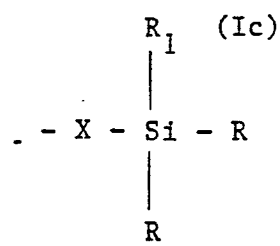
(Ic)

dans lesquelles $R_1$ représente un radical hydrocarboné à insaturation alcénique ou alcynique et les radicaux R, identiques ou différents, ont la signification donnée ci-dessus et pouvant être en outre un radical $R_1$, les symboles X identiques ou différents représentent les chainons $(CH_2)_n$ (avec n étant un nombre entier compris entre 1 et 8), -Si- et N-, au moins 50 % des X étant N- ; et

- une quantité efficace d'un générateur de radicaux libres.

Bien entendu, la présente invention vise les compositions organopolysilazanes comportant un mélange quelconque d'organopolysilazanes (1) et (2).

Dans les polysilazanes (2), les motifs autres que (Ia), (Ib), ou (Ic) peuvent être des motifs pouvant se retrouver dans les polysilazanes (1) choisis parmi les motifs de formules :

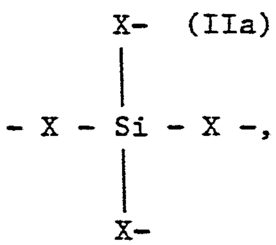 (IIa), 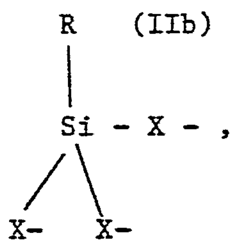 (IIb), 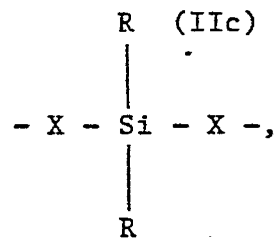 (IIc), 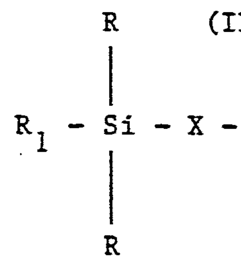 (IId)

dans lesquelles les radicaux R et les chainons X identiques ou différents ont la signification ci-dessus.

Dans les formules (I), (Ib) et (Ic), (IIb), (IIc) et (IId), le radical R peut être outre un atome d'hydrogène, un radical hydrocarboné aliphatique saturé, de préférence ayant de 1 à 8 atomes de carbone, comme un radical méthyle, éthyle, propyle, butyle, pentyle, hexyle, heptyle et octyle ; le radical R peut être également un radical hydrocarboné cyclique saturé ayant de 3 à 7 atomes de carbone comme le radical cyclopropyle, cyclobutyle, cyclopentyle, cyclohexyle et cycloheptyle ; R peut être un radical arylalkyle comme les radicaux benzyle et phényléthyle, ou un radical alkylaryle comme les radicaux tolyle et xylyle. Les radicaux méthyle et phényle sont les radicaux préférés. Dans les formules (Ia), (Ib) et (Ic), le radical $R_1$ peut être un radical aliphatiquement insaturé ayant de préférence de 2 à 8 atomes de

carbone on peut citer les radicaux éthynyle, propynyle etc... les radicaux vinyle, allyle etc... et les radicaux cycloalcényle, comme les cyclopentényle, cyclohexényle, cycloheptényle et cyclooctényle. Le radical vinyle est le radical préféré.

Les organopolysilazanes (2) sont, comme les organopolysilazanes (1) des produits bien connus dont la préparation est décrite en détail dans la littérature, comme par exemple dans le Journal of Polymer Science A 2 3179 (1964) et par Redl, Silazane Polymer, Arpa-19, Advanced Research Projects Agency, Octobre 1965, dans les brevets US 3.853.567 et 3.892.583, dans le brevet européen 75826 et dans le brevet français 2.497.812.

Ils peuvent être par exemple formés par réaction d'un organohalogénosilane de formule (VI) :

$$(R)_a\ (R_1)_b\ Y_{4-(a+b)}\ Si \qquad (VI)$$

avec R, $R_1$ et Y ayant la signification ci-dessus et a égal à 0, 1 ou 2 ; b égal à 1, 2 ou 3 et a + b inférieur ou égal à 3, sur un composé organique comportant au moins un groupement $NH_2$ ou NH y compris $NH_3$ tel que défini ci-dessus pour la synthèse des organopolysilazanes (1).

On peut bien entendu utiliser les mélanges possibles des silanes de formule (I) (V) et (VI).

Les silanes de formules (VI) les plus utilisés sont :

$CH_3(CH_2{=}CH)SiCl_2$, $(CH_3)_2\ (CH_2{=}CH)SiCl$ ;

$(C_6H_5)_2\ (CH_2{=}CH)SiCl$, $(CH_3)(C_6H_5)(CH_2{=}CH)SiCl$ ;

$(C_6H_5)(CH_2{=}CH)SiCl_2$

Les polysilazanes de départ préparés à partir d'ammoniac sont généralement appelés ammonolysats et les polysilazanes de départ préparés à partir d'un composé aminé comme indiqué ci-dessus sont appelés aminolysats qui incluent donc les ammonolysats.

Par ailleurs, dans les aminolysats, du type organopolysilazane, on distingue les motifs :

$M^N$ : 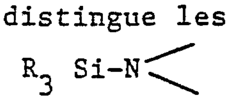

$D^N$ : 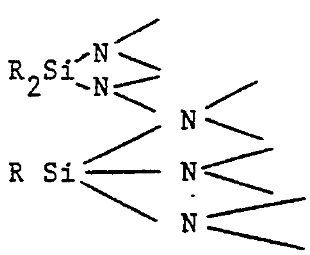

$T^N$ :

Comme générateur de radicaux libres, on peut en particulier utiliser les peroxydes organiques encore plus particulièrement ceux déjà utilisés pour vulcaniser les compositions organopolysiloxanes réticulant à chaud par exemple ceux décrits aux pages 392 et 393 de l'ouvrage de Walter NOLL, Chemistry and Technology of Silicones (1968) ou les péroxydes organiques utilisés plus particulièrement pour les polymérisations vinyliques et décrits dans Plastics Design et Processing, Février 1980, p. 38 à 45 et dans Kunstoffe, volume 62, Octobre 1972, p. 39 à 41.

Les peroxydes incluent notamment les peroxydes de diaroyle comme le peroxyde de dibenzoyle, le peroxyde de di-p-chlorobenzoyle, le peroxyde de bis dichloro-2,4 benzoyle ; les peroxydes de dialkyle tels que le diméthyl-2,5 di-(t-butylperoxy)-2,5 hexane et le peroxyde de di-t-butyle ; les peroxydes de diarallyle tels que le peroxyde de dicumyle ; les peroxydes d'alkyle et d'aralkyle tel que le peroxyde de t-butyle et de cumyle et le bis-1,4(t-butylperoxyisopropyle)benzène ; les peroxydes d'alkyl et d'aroyle et les peroxydes d'alkyle et d'acyle comme le perbenzoate de t-butyle, le peracétate de t-butyle et le peroctoate de t-butyle.

On peut également utiliser les peroxysiloxanes comme par exemple décrit dans le brevet américain US-A 2.970.982 et les peroxycarbonates tel que le carbonate de t-butylperoxyisopropyl.

On préfère toutefois utiliser des générateurs de radicaux libres qui ne contiennent pas d'atomes d'oxygène ou de soufre dont la présence n'est pas désirée dans les produits précurseurs pour céramiques.

Parmi ces composés on peut utiliser les composés azoiques symétriques ou dissymétriques comme :

- l'azo-2,2'-bis (isobutyronitrile) qui convient particulièrement ainsi que
- l'azo-2,2'-bis (diméthyl-2,4 méthoxy-4) valeronitrile
- le cyano-1 (t-butylazo)-1 cyclohexane
- le (t-butylazo)-2 isobutyronitrile.

Ces produits sont bien connus et sont en particulier décrits dans les 2 dernières publications citées pour les péroxydes et dans les brevets américains US-A 2.500.029, US-A 2.492.763 et US-A 2.515.628.

On peut également utiliser les azonitriles contenant des groupes amines tertiaires tels que l'azo-bis-(γ diethylamino α methylbutyronitrile) décrits dans le brevet américain US-A 2.605.260.

Parmi ces produits l'azo-2,2'-bis(isobutyronitrile) de formule :

$$CN(CH_3)_2\ C - N = N - C\text{-}(CH_3)_2CN$$

convient plus particulièrement.

Par quantité efficace de générateur de radicaux libres, on entend une quantité suffisante pour réticuler convenablement l'organopolysilazane. La concentration en générateur de radicaux est généralement comprise entre 0,1 et 50 g par kg d'organopolysilazane ; cette concentration peut aller jusqu'à 200 g par kg pour les générateurs du type azobisisobutyronitrile qui ne comportent pas d'atomes pouvant affecter les propriétés de la céramique.

En vue de réticuler la composition organopolysilazane on apporte à ladite composition de l'énergie suivant une quantité suffisante et sous une forme susceptible d'engendrer lesdits radicaux libres.

On peut ainsi réticuler la composition par chauffage à une température comprise entre 40 et 400°C, de préférence entre 100 et 220°C. Des rayonnements sont également utilisables comme les faisceaux d'électrons, quelle que soit l'épaisseur, et également les rayons ultraviolets pour les couches minces inférieures à 100 µm.

Dans l'application revêtement, pellicules, couches minces, la composition est de préférence utilisée sans solvant. Dans ce cas, les polysilazanes (1) et (2) sont choisis de telle sorte que la viscosité de la composition à 25°C soit comprise entre 1 et 5000 mPa.s.

Des viscosités supérieures peuvent être utilisées, mais il est alors nécessaire quand on veut utiliser les compositions pour enduire ou imprégner un support, de solubiliser la composition dans un solvant organique compatible avec les polysilazanes comme le benzène, le toluène, l'hexane, le cyclohexane, l'éther isopropylique, l'éther éthylique, le dichlorométhane et le chlorobenzène.

Dans l'application fibres on doit utiliser des viscosités supérieures à 5000 mPa.s. On peut opérer sans solvant à l'état fondu ou en solution, la réticulation s'effectuant à la sortie de la filière par passage dans un four et/ou sous rayonnement (UV, faisceaux d'électron).

Les compositions polysilazanes selon l'invention peuvent contenir en outre des charges de préférence choisies parmi $SiO_2$, $Si_3N_4$, SiC, BN, $B_2O_3$, $B_4$ C, AlN , $Al_2O_3$ , $Al_4C_3$, TiN, $TiO_2$, TiC, $Z_rO_2$, $Z_rC$, $VO_2$ etc...

La composition polysilazane selon l'invention peut en outre servir de matrice pour des fibres céramiques réalisées notamment en SiC, $SiO_2$, $Si_3N_4$, $B_4C$ etc...

La composition polysilazane selon l'invention est particulièrement utile pour revêtir ou imprégner des supports rigides ou souples en métal ou en fibres céramiques.

Pour réticuler les compositions polysilazanes selon l'invention on peut opérer sous vide ou sous pression de gaz inerte ou sous atmosphère inerte durant un temps adapté à la nature du générateur de radicaux libres et à son temps de demi-vie, ce temps étant généralement compris entre 1 mn et 24 h.

Il est cependant possible de réticuler les polysilazanes à l'atmosphère ambiante et également de conserver les réticulats obtenus à l'atmosphère ambiante. On a en effet pu mettre en évidence que ces réticulats présentaient une résistance tout à fait inattendue aux réactions de dégradation provoquées par l'oxygène et l'humidité de l'air.

Les supports recouverts ou imprégnés de la composition durcie, ou les fibres, peuvent subir immédiatement ou ultérieurement un traitement de pyrolyse de préférence sous vide ou sous pression ou sous atmosphère inerte avec une montée en température allant de la température de réticulation à 1500-2000°C, suivant la nature de la céramique ou du liant désirée.

La composition selon l'invention et le procédé de réticulation de cette composition permettent donc de faire des demi-produits intermédiaires pouvant être conservés à l'air ambiant et qui peuvent être ultérieurement pyrolysés.

Ceci constitue donc un procédé particulièrement avantageux pour déposer ou imprégner sur un support une matière céramique, et pour obtenir des fibres de céramique et des liants de frittage.

Dans les exemples suivants, illustrant l'invention sans en limiter la portée, on analyse les polysilazanes obtenus traités catalytiquement ou non, par thermogramométrie dynamique (TGA) en les pyrolysant de la température ambiante (20°C) à 1400°C sous azote avec une vitesse de montée en température de 2°C/min. On indique dans les exemples le rendement TGA (% en poids de résidu solide à 1300-1500°C).

Les propriétés mécaniques des compositions réticulées sont appréciées par la variation de la rigidité relative RR en fonction de la température.

La viscosité est mesurée à 25°C et est donnée en mPa.s dans les formules Me = $CH_3$, Vi = $CH_2$=CH.

Les réactions d'ammonolyse et de coammonolyse sont effectuées dans un premier réacteur I de 3 litres de forme cylindrique (muni d'une double enveloppe pour refroidir le volume réactionnel). Le réacteur est surmonté d'un condenseur de gaz. L'agitation mécanique est assurée par deux turbines RUSHTON ® (une turbine à pales droites, une turbine à pales inclinées) disposées le long de l'arbre d'agitation. L'introduction de gaz $N_2$ et $NH_3$ se fait pas l'intermédiaire d'un tube fin plongeant dans la solution de façon à faire apparaitre $NH_3$ juste sous la lère turbine d'agitation. En fin d'ammonolyse le mélange réactionnel est soutiré et est introduit dans un réacteur II muni d'une agitation mécanique (turbine RUSHTON ® à pales droites) et d'un lit filtrant (porosité moyenne 10 µm). Les ammonolysats sont filtrés et les solvants de rinçage sont introduits dans un réacteur III de 6 litres muni d'une double enveloppe et d'une agitation mécanique, d'une turbine de RUSHTON ® à pales droites, et est inerté sous $N_2$ ou mis sous un vide de 25 mbar. A la sortie du réacteur III la solution contenant l'ammonolysat est introduite dans un évaporateur rotatif.

L'ensemble de l'installation est mise sous atmosphère inerte plusieurs heures avant la manipulation. L'ensemble de la réaction, ammonolyse, filtration, évaporation du solvant se fait sous azote sec. Les produits obtenus sont placés dans des flacons étanches

inertés à l'azote et sont conservés, pesés, manipulés sous boîte à gants inertée à l'azote. Dans ce qui suit sauf indications contraires les % indiqués sont en poids.

EXEMPLE 1

203 g de $MeViSiCl_2$ (1,44 mole) de pureté > 99 % sont placés dans le réacteur I en présence de 1,3 litre d'éther isopropylique.

On introduit l'ammoniac dans le réacteur I avec un débit de 6 $cm^3$/s additionné de $N_2$ avec un débit de 3 $cm^3$/s pendant 6 H 30 (soit environ 0,1 mole de $NH_3$ introduits). La température du réacteur I est maintenue à 2°C pendant l'introduction de $NH_3$ (5 heures) et est portée à 20°C toujours avec introduction de $NH_3$ pendant 1 h 30. Le chlorure d'ammonium éliminé est séché sous vide et pesé.

Après élimination du solvant sous vide (25 mbar à 60°C puis 1,5 mbar à 60°C pendant 1 heure), on récupère 119 g d'un liquide limpide peu visqueux (3 mPa.s). Le rendement pondéral de la réaction est de 97 %.

Les solvants récupérés sont analysés par chromatographie en phase gazeuse pour identifier et quantifier le taux de volatils éliminés lors de la dévolatilisation du produit.

Le produit a été analysé par IR, RMN du proton, RMN du $^{29}Si$ et chromatographie en phase gazeuse. Il est constitué principalement de deux produits cycliques :

$D_3^{NVi}$ =

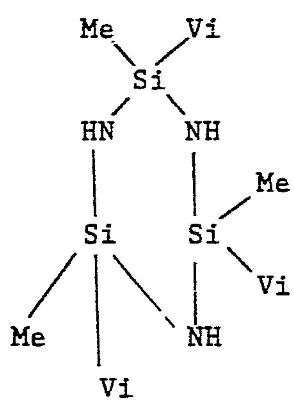

89 % molaire

et $D_4^{NVi}$ : 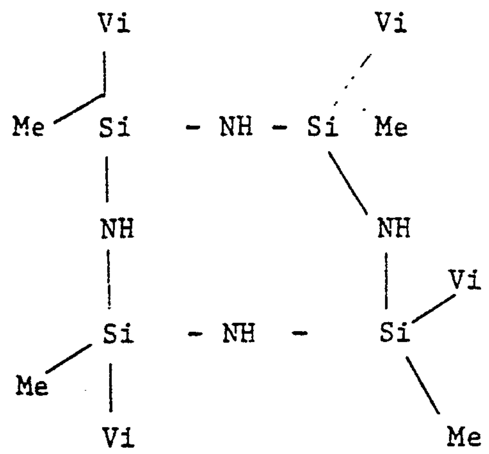 11 % molaire

EXEMPLE 2

207,5 g de $CH_3HSiCl_2$ (1,8 mole) de pureté > 99 % sont placés dans le réacteur I en présence de 1,2 litre d'éther isopropylique. On introduit l'ammoniac dans le réacteur I avec un débit de 6 $cm^3/s$ additionné de $N_2$ avec un débit de 3 $cm^3/s$ pendant 7 H 30 (soit environ 7 moles de $NH_3$ introduits). La température du réacteur I est maintenue à 2°C pendant l'introduction de $NH_3$ (6 heures) et est portée à 20°C toujours avec introduction de $NH_3$ pendant 1 h 30. Le chlorure d'ammonium éliminé est séché sous vide et pesé (188 g pour un poids théorique de 192,6 g).

Après élimination du solvant sous vide (25 mbar à 60°C puis 1,5 mbar à 60°C pendant 1 heure), on récupère 84 g d'un liquide limpide peu visqueux. Le rendement pondéral de la réaction est de 79 %.

Les solvants récupérés sont analysés par chromatographie en phase gazeuse pour identifier et quantifier le taux de volatils éliminés lors de la dévolatilisation du produit.

Le produit lui même est analysé par IR, RMN du $^{29}Si$ et RMN du proton $^1H$.RMN 360 MHz $C_6D_6$ : $\delta$ = 0,1 - 0,4 ppm (large : $SiCH_3$) $\delta$ = 0,6 à 1,5 ppm (large : NH) $\delta$ = 4,1 ppm (large : SiH) $\delta$ = 4,5 - 4,7 ppm (large : SiH) $\delta$ = 4,8 - 5,0 ppm (large : SiH).

L'analyse par chromatographie liquide indique la présence de plusieurs produits de faibles masses moléculaires évaluées entre 300 et 450 g/mole.

Le dosage chimique du produit indique une teneur en hydrogène du produit = 1,66 % (1,70 % théorique). Ce résultat est en accord avec les indications données par les méthodes spectrales.

EXEMPLE 3

On effectue la coammonolyse suivant le procédé de l'exemple 1, de :

- 107,2 g de $CH_3SiCl_3$ (0,72 mole)
- 46,25 g de $(CH_3)_2SiCl_2$ (0,36 mole)
- 50,76 g de $CH_3(CH_2=CH)SiCl_2$ (0,36 mole)

On opère en présence de 1,3 litre d'éther isopropylique. La réaction s'effectue à 2°C avec un débit de $NH_3$ = 6 $cm^3$/s pendant 6 H 45. On récupère 98,7 g d'une huile visqueuse de viscosité 110 mPa.s, soit un rendement pondéral de la coammonolyse de 95 %.

Le produit a été identifié par RMN du $^{29}Si$, RMN du proton et IR. Sa composition correspond bien à celle des produits engagés $T^N/D^N$ = 1 et $D^{NVi}/D^N$ = 1.

EXEMPLE 4

2 moles de $Me_2SiCl_2$ (258 g) de pureté supérieure à 99 % sont ammonolysés selon le mode opératoire de l'exemple 1 dans 1,3 l d'éther isopropylique sec. La réaction est effectuée à 2°C avec un débit de $NH_3$ de 10 $cm^3$/s pendant 6 h. Après filtration de $NH_4Cl$ on récupère 140 g d'un silazane cyclique. Par rectification à 188°C, on récupère $D_3^N$ séché sur $CaCl_2$.

EXEMPLES 5 à 8

On introduit dans un réacteur capable de supporter une pression de 10 bars l'organopolysilazane préparé à l'exemple 1 avec des concentrations croissantes de générateur de radicaux libres. Le réacteur est porté à la température désirée pour la réaction. Les résultats sont rassemblés dans le tableau I ci-après :

TABLEAU I

| EX. | GENERATEUR | CONCENTRATION DU GENER. g/kg DE POLYSILAZANE | T°C | DUREE EN h | ASPECT à 25°C | TGA % |
|---|---|---|---|---|---|---|
| 5 | - | - | 170°C | 15 h | Liquide | 0 |
| 6 | AIBN | 1,6 | 170°C | 15 h | Liquide | 35 |
| 7 | AIBN | 16 | 170°C | 15 h | Liquide visqueux | 41 |
| 8 | AIBN | 160 | 170°C | 3 h | Solide | 60 |

EXEMPLES 9 à 12

On réticule le coammonolysat de l'exemple 3 suivant le mode opératoire des exemples 5 à 8. Les résultats sont rassemblés dans le tableau II ci-après :

TABLEAU II

| EX. | GENERATEUR | CONCENTRATION DU GENER. g/kg DE POLYSILAZANE | T°C | DUREE EN h | ASPECT à 25°C | TGA % |
|---|---|---|---|---|---|---|
| 9 | - | - | 170°C | 24 h | Liquide | 37 |
| 10 | AIBN | 1,6 | 170°C | 24 h | Liquide | 47 |
| 11 | AIBN | 16 | 170°C | 24 h | Liquide visqueux | 52 |
| 12 | AIBN | 160 | 170°C | 3 h | Liquide très visqueux | 63 |

EXEMPLES 13 à 15

On utilise l'organopolysilazane obtenu par ammonolyse de $MeViSiCl_2$ décrite à l'exemple 1. Le produit est réticulé pendant 24 heures à 170°C sous $N_2$ en présence de peroxydes A ou B (formule décrite ci-dessous) suivant le mode opératoire décrit aux exemples 5 à 8.

A/ Peroxyde de cumyle

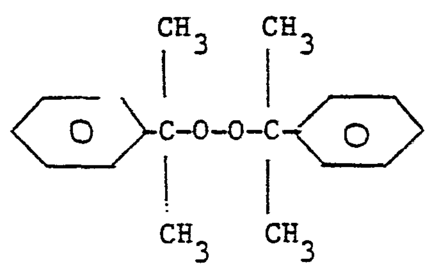

B/ Diméthyl-2,5 di(tertiobutylperoxy)-2,5 hexane :

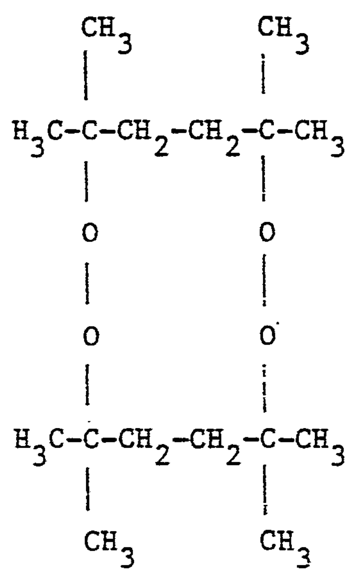

Les résultats obtenus sont rassemblés dans le tableau III ci-après :

TABLEAU III

| EXEMPLE | GENERATEUR | CONCENTRATION EN $g/kg^{-1}$ | ASPECT à 25°C | TGA EN % |
|---|---|---|---|---|
| 13 | - | - | Liquide | 0 |
| 14 | A | 27 | Solide | 72,5 |
| 15 | B | 29 | Solide | 74 |

EXEMPLE 16

On utilise un mélange d'ammonolysat (13,25 g) préparé à l'exemple 2 et du coammonolysat (43,25 g) préparé à l'exemple 3 en quantités telles que l'on ait un rapport SiH/SiVi sensiblement égal à 1,5. On réticule le produit suivant le procédé des exemples 5 à 8 ; le générateur de radicaux libre est l'AIBN à une teneur de 1,6 g/kg. Les résultats sont rassemblés dans le tableau IV ci-après dans lesquels on a réécrit les résultats obtenus à l'exemple 10 pour montrer l'intérêt de l'utilisation du mélange de l'exemple 16.

TABLEAU IV

| EXEMPLE | T°C | Durée | ASPECT à 25°C | TGA EN % |
|---|---|---|---|---|
| 10 | 170°C | 24 h | Liquide | 47 |
| 16 | 170°C | 24 h | Solide | 60 |

EXEMPLES COMPARATIF 17 ET EXEMPLE 18

On réticule selon l'exemple 18, suivant le mode opératoire des exemples 5 à 8, le $D_3^N$ obtenu à l'exemple 4, par de l'AIBN à une concentration de 16 g/kg. Les résultats sont rassemblés dans le tableau V ci-après. Pour l'exemple comparatif 17, on procéde de la même façon mais sans AIBN.

TABLEAU V

| EXEMPLE | GENERATEUR | Durée en R | T°C | Aspect à 25°C | TGA EN % |
|---|---|---|---|---|---|
| 17 | - | 15 h | 170 | Liquide | 0 |
| 18 | AIBN | 15 h | 170 | Solide | 20 |

EXEMPLE 19

On polymérise en masse dans un réacteur tricol 0,42 mole de $D_3^N$ de l'exemple 4 par 300 ppm d'acide trifluorométhanesulfonique pendant 15 h à 165°C. Le polymère obtenu est désactivé puis dévolatilisé 1/2 h à 170°C sous 1,3 millibars. Le polysilazane est réticulé par 16 g/kg d'AIBN pendant 20 h à 140°C. L'analyse TGA du produit final est de 54 %.

## REVENDICATIONS

1) Composition organopolysilazane susceptible de réticuler par apport d'énergie, caractérisée en ce qu'elle comporte une quantité efficace d'au moins un générateur de radicaux libres.

2) Composition selon la revendication 1, caractérisée en ce que l'organopolysilazane comporte par molécule au moins 1 groupe $\equiv SiR_1$, $R_1$ étant un radical hydrocarboné présentant une insaturation alcénique ou alcynique.

3) Composition selon la revendication 2, caractérisée en ce que le radical $R_1$ est un radical vinyle.

4) Composition selon l'une quelconque des revendications précédentes caractérisée en ce que le générateur de radicaux libres est un composé azoïque, de préférence l'azo-2,2'-bis (isobutyronitrile).

5) Composition selon l'une quelconque des revendications 1 à 3 caractérisée en ce que le générateur de radicaux libres est un peroxyde organique.

6) Composition selon l'une quelconque des revendications précédentes, caractérisée en ce qu'elle comporte en outre des charges.

7) Composition selon l'une quelconque des revendications précédentes, caractérisée en ce qu'elle est utilisée sans solvant, les organopolysilazanes étant choisis de telle sorte que la viscosité de la composition à 25°C soit comprise entre 1 et 5000 mPa.s.

8) Composition selon l'une quelconque des revendications 1 à 6, utilisable pour filer des fibres, caractérisée en ce que les organopolysilazanes sont choisis de telle sorte que la viscosité soit supérieure à 5000 mPa.s et en ce que la composition est à l'état fondu sans solvant ou en solution dans un solvant.

9) Procédé de réticulation d'une composition conforme à l'une quelconque des revendications 1 à 8, caractérisé en ce qu'on apporte à ladite composition de l'énergie suivant une quantité suffisante et sous une forme susceptible d'engendrer lesdits radicaux libres.

0202177

10) Procédé selon la revendication 9, caractérisé en ce qu'on chauffe la composition à une température comprise entre 40 et 400°C.

11) Procédé pour recouvrir et imprégner un support d'un matériau céramique caractérisé en ce que :

- on enduit ou on imprègne ledit support d'une composition conforme à l'une quelconque des revendications 1 à 5,

- on réticule la composition et,

- on pyrolyse le revêtement par un traitement thermique allant de la température de réticulation à 1500-2000°C.

Office européen
des brevets

# RAPPORT DE RECHERCHE EUROPEENNE

0202177

Numéro de la demande

EP 86 42 0114

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | DE-A-2 708 635 (RESEARCH INSTITUTE FOR IRON, STEEL AND OTHER METALS) * Revendications 1,7,8 * | 1 | C 08 G 77/62<br>C 08 L 83/16 |
| A | US-A-3 702 317 (L.W. BREED) * Revendications 1,3 * | 1 | |
| A | US-A-2 579 418 (N.D. CHERONIS) * Revendication 1 * | 1 | |
| A | US-A-3 803 086 (L.W. BREED) * Revendication 1 * | 1 | |
| | | | DOMAINES TECHNIQUES RECHERCHES (Int. Cl.4) |
| | | | C 08 L<br>C 08 G<br>C 04 B |

Le présent rapport de recherche a été établi pour toutes les revendications

| Lieu de la recherche | Date d'achèvement de la recherche | Examinateur |
|---|---|---|
| LA HAYE | 19-08-1986 | DEPIJPER R.D.C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention
E : document de brevet antérieur, mais publié à la date de dépôt ou après cette date
D : cité dans la demande
L : cité pour d'autres raisons
& : membre de la même famille, document correspondant